# EUROPÄISCHE PATENTANMELDUNG

(11) **EP 2 672 566 A1**
(43) Veröffentlichungstag der Anmeldung: **11.12.2013**
(21) Anmeldenummer: 13170482.7
(22) Anmeldetag: 04.06.2013
(51) Int. Cl.: H01Q 1/32, H03K 17/955

(54) **Elektrodenanordnung für ein Fahrzeug und Verwendung einer solchen Elektrodenanordnung**

(30) Priorität: 05.06.2012 DE 102012011127; 26.09.2012 DE 102012217402
(71) Anmelder: Johnson Controls Automotive Electronics GmbH, 75196 Remchingen (DE)
(72) Erfinder: Rawer, Marc, 70327 Stuttgart (DE); Arheit, Thomas, 76356 Weingarten (DE)
(74) Vertreter: Finger, Catrin

(57) **Zusammenfassung**

Die Erfindung betrifft eine Elektrodenanordnung für ein Fahrzeug mit einem Sensorelement (A), welches durch einen Teil eines aus Kunststoff und/oder einem anderen nicht leitfähigen Material gefertigten Zier- oder Dekorelements (1) gebildet ist, wobei das Zier- oder Dekorelement (1) zumindest abschnittsweise metallisiert ausgeführt ist und der metallisierte Abschnitt (2) des Zier- oder Dekorelements (1) als Sensorelement (A) elektrisch angebunden ist, wobei zumindest der metallisierte Abschnitt (2) des Zier- oder Dekorelements (1) die Elektrode eines Kondensators bildet. Erfindungsgemäß bildet das Sensorelement (A) eine Annäherungselektrode ist und ein sich annäherndes Objekt eine Gegenelektrode.

Die Erfindung betrifft weiterhin eine Verwendung einer solchen Elektrodenanordnung zur Detektion sich dem Fahrzeug nähernder Objekte.

Das Sensorelement ist somit als solches nicht sichtbar und erkennbar und in besonders einfacher Weise in das Fahrzeug zu integrieren.

## Beschreibung

Die Erfindung betrifft eine Elektrodenanordnung für ein Fahrzeug, bei dem ein Sensorelement durch einen Teil eines aus Kunststoff und/oder einem anderen nichtleitfähigen Material gefertigten Zier- oder Dekorelements gebildet ist, wobei das Zier- oder Dekorelement zumindest abschnittsweise metallisiert ausgeführt ist und der metallisierte Abschnitt des Zier- oder Dekorelements als Sensorelement elektrisch angebunden ist, wobei zumindest der metallisierte Abschnitt des Zier- oder Dekorelements die Elektrode eines Kondensators bildet.

Zudem betrifft die Erfindung eine Verwendung einer solchen Elektrodenanordnung.

Elektrodenanordnungen im Fahrzeug sind hinlänglich bekannt. Üblicherweise dienen diese im Fahrzeug der Kommunikation zum Beispiel mit einem Rundfunk- und/oder Mobilfunksystem. Darüber hinaus sind fahrzeugeigene Elektroden für Fahrerassistenzsysteme, wie zur Ermittlung von Abständen des Fahrzeugs zu anderen Objekten zur Realisierung von Abstandsradarsystemen oder Einparkhilfen, bekannt.

Die DE 100 36 131 A1 beschreibt einen Radarsensor zur Erfassung der Verkehrssituation im Umfeld eines Kraftfahrzeugs. Der Radarsensor weist ein Trägerelement mit einem Array von Patchantennen in Form einer Kombination eines gefüllten Subarrays von Patchantennen und eines ausgedünnten Subarrays von Patchantennen auf. Zudem ist eine integrierte mm-Wellenschaltung zur Abmischung des Empfangssignals und zur Aufbereitung des Lokaloszillators sowie ein integrierter Schaltkreis, der einen Analog-/Digitalwandler und einen digitalen Signalprozessor für ein Erfassen des Ausgangssignals des gefüllten Subarrays nach Amplitude und Phase und des Ausgangssignals des ausgedünnten Subarrays nach Amplitude und Phase aufweist und Versorgungsleitungen vorgesehen sind. Die Patchantennen sind auf einer Außenseite des Trägerelementes ausgebildet, wobei auf der anderen Außenseite des Trägerelementes der integrierte Schaltkreis, die integrierte mm-Wellenschaltung und die Versorgungsleitungen angeordnet sind.

Darüber hinaus ist aus der DE 100 36 132 A1 ein Verfahren zur Unterdrückung von Kombinationszielen bei multiplikativer Verarbeitung der Signale eines Radarsensors, der insbesondere zur Erfassung der Verkehrssituation im Umfeld eines Kraftfahrzeuges dient, bekannt. Dazu weist der Radarsensor ein Array von Patchantennen auf.

Des Weiteren sind verschiedene Antennenanordnungen in der DE 101 13 285 A1, der EP 0 383 017 A2, der US 6,667,719 B2, der EP 1 667 282 A1, der US 2010/0321253 A1, der DE 10 2004 023 467 A1 und der US 6,973,709 B2 offenbart.

Aufgabe der vorliegenden Erfindung ist es, eine gegenüber dem Stand der Technik verbesserten Elektrodenanordnung und eine Verwendung einer solchen Elektrodenanordnung anzugeben.

Hinsicht der Elektrodenanordnung wird die Aufgabe erfindungsgemäß durch die im Anspruch 1 angegebenen Merkmale und hinsichtlich der Verwendung durch die in Anspruch 6 angegebenen Merkmale gelöst.

Vorteilhafte Ausgestaltungen der Erfindung sind Gegenstand der Unteransprüche.

Die Elektrodenanordnung für ein Fahrzeug umfasst ein Sensorelement, welches durch einen Teil eines aus Kunststoff und/oder einem anderen nichtleitfähigen Material gefertigten Zier- oder Dekorelements gebildet ist, wobei das Zier- oder Dekorelement zumindest abschnittsweise metallisiert ausgeführt ist und der metallisierte Abschnitt des Zier- oder Dekorelements als Sensorelement elektrisch angebunden ist, wobei zumindest der metallisierte Abschnitt des Zier- oder Dekorelements die Elektrode eines Kondensators bildet. Erfindungsgemäß ist das Sensorelement eine Annäherungselektrode und ein sich annäherndes Objekt bildet eine Gegenelektrode.

Dadurch, dass das Sensorelement, d. h. die Annäherungselektrode, mittels eines Zier- oder Dekorelements gebildet ist, ist es in besonders vorteilhafter Weise möglich, das Sensorelement, welches somit als solches nicht sichtbar und erkennbar ist, in besonders einfacher Weise in das Fahrzeug zu integrieren. Dabei bildet der metallisierte Abschnitt Annäherungselektrode der Elektrodenanordnung, so dass diese einen Annährungssensor bildet. Insbesondere kann ein Bereich des Zier- oder Dekorelements mit einer Metallfolie, einer Metallbeschichtung und/oder einer Leiterstruktur versehen sein, um als metallisierter Abschnitt ausgeführt zu sein. Auch kann vorteilhaft vorgesehen sein, dass als Abschnitt ein umlaufender Rahmen des Zier- oder Dekorteiles metallisiert ist und somit eine Ringantenne gebildet ist.

Dadurch, dass das Zier- oder Dekorelement aus Kunststoff oder einem anderen nichtleitfähigen Material gefertigt und zumindest abschnittsweise metallisiert ausgeführt ist, um die Annäherungselektrode zu bilden, kann der vorgesehene Abschnitt, wie oben beschrieben, metallisiert werden. Somit ist eine vollständige Ausbildung des Zier- und Dekorelements aus Metall nicht erforderlich. Dadurch werden eine Material-, Gewichts- und Kosteneinsparung erzielt.

Dabei wird dieser metallisierte Abschnitt des Zier- oder Dekorelements elektrisch angebunden und als Annäherungselektrode, auch als Proximity-Elektrode bekannt, genutzt. Dadurch, dass der Abschnitt metallisiert, also mit einem elektrisch leitfähigen Material versehen ist, kann ein Strom fließen, um die Funktion der Annäherungselektrode sicherzustellen.

Somit dient der metallisierte Abschnitt des Zier- oder Dekorelements als Elektrode eines Kondensators und ein sich annäherndes Objekt, z. B. ein Mensch, bildet besonders vorteilhaft eine Gegenelektrode und dient gleichzeitig der Erdung.

Gemäß einer Weiterbildung ist die Elektrodenanordnung eine Antennenanordnung, wobei das Sensorelement und somit die Annäherungselektrode eine Antenne bildet.

In einer Ausgestaltung ist das als Zier- oder Dekorelement ausgebildete Sensorelement in dem Fahrzeug oder außen am Fahrzeug angeordnet, wodurch dem Sensorelement unterschiedliche Funktionen zugeordnet werden können. Ist das Sensorelement beispielsweise außen am Fahrzeug angeordnet, kann es Bestandteil einer Diebstahlsicherung sein und/oder zur Abstandswarnung eingesetzt werden.

Bevorzugt ist das Sensorelement in eine Fahrzeuginnen- oder Fahrzeugaußenhaut als Zier- oder Dekorelement integriert, so dass das Sensorelement für einen Betrachter nicht sichtbar ist und dadurch beispielsweise nicht mutwillig von Unbefugten zerstört werden kann.

Ist das Dekorelement Bestandteil der Fahrzeugaußenhaut, kann es sich bei dem Zier- oder Dekorelement beispielsweise um ein Abdeck-, Zier- oder Verkleidungsteil, beispielsweise einer A-, B- oder C-Säule handeln. Denkbar ist auch, dass das Sensorelement als Dekorelement in eine Dachreling integriert ist.

In einer möglichen Ausführungsform ist das Zier- oder Dekorelement, an welchem zumindest ein Abschnitt zur Bildung der Annäherungselektrode metallisiert ist, Bestandteil einer Anzeigeeinheit in dem Fahrzeuginnenraum, wobei die Anzeigeeinheit vorteilhaft beispielsweise in eine Armaturtafel oder eine Sitzlehne integriert sein kann. Dabei kann die Annäherungselektrode in Form des metallisierten Abschnittes die Anzeigeeinheit umlaufend ausgebildet sein, wodurch die Anzeigeeinheit mittels der Annäherungselektrode optisch aufgewertet ist.

Wie oben beschrieben, dient ein sich dem Zier- oder Dekorelement annäherndes Objekt als Gegenelektrode und als Erdung zugleich, wodurch die Elektrodenanordnung unmittelbar innen oder außen am Fahrzeug im Bereich der Fahrzeugaußen- oder-innenhaut zur Detektion beispielsweise sich dem Fahrzeug annähernder Objekte eingesetzt werden kann. Darüber hinaus ist die Annäherungselektrode auch zur Detektion einer Bewegung einer Person, die die Gegenelektrode bildet, einsetzbar. Dadurch ist es in besonders vorteilhafter Weise möglich, die Annäherungselektrode als Detektionseinheit verschiedener Assistenzsysteme des Fahrzeugs einzusetzen.

In einer besonders bevorzugten Ausführungsform wird die Annäherungselektrode zur Erfassung eines Objektes und seinem Abstand zu dem Fahrzeug eingesetzt und in Abhängigkeit des erfassten Abstandes zumindest eines detektierten Objektes zu dem Fahrzeug wird eine Warnung vor einer bevorstehenden Kollision im Fahrzeug ausgegeben. Die Annäherungselektrode dient also als Erfassungseinheit und kann beispielsweise Bestandteil einer Parkassistenzvorrichtung und/oder einer Abstandsregelvorrichtung des Fahrzeuges sein.

Anhand der einzigen beigefügten schematischen Figur wird die Erfindung näher beschrieben.

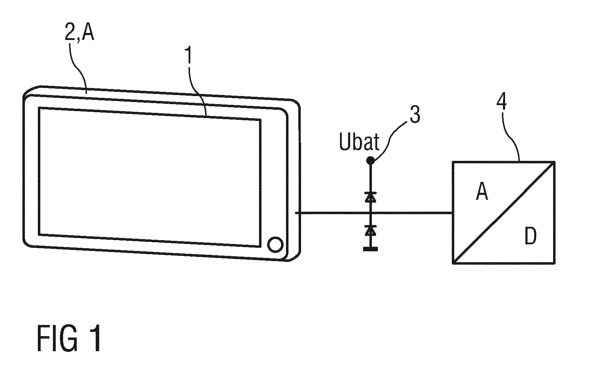

Die einzige Figur zeigt schematisch ein Dekorelement 1. Das Dekorelement 1 ist im Ausführungsbeispiel eine Anzeigeeinheit, welche beispielsweise in einer Armaturentafel oder einer Sitzlehne eines Fahrzeugs angeordnet sein kann.

Alternativ kann das Dekorelement 1 Teil der Fahrzeugaußenhaut, insbesondere ein Abdeck-, Zier- oder Verkleidungsteil der Fahrzeugaußenhaut, z. B. eine Verkleidung einer A-, B- oder C-Säule, sein.

Das Dekorelement 1 ist herkömmlich aus Kunststoff, Gummi oder einem anderen geeigneten nichtleitenden Trägermaterial gebildet. Zumindest ein Abschnitt 2 ist metallisiert ausgebildet. Im Ausführungsbeispiel ist als Abschnitt 2 ein umlaufender Rahmen des Dekorelements 1 metallisiert ausgeführt, so dass ein Sensorelement A in Form einer Ringelektrode, beispielsweise einer Ringantenne, gebildet ist. Der Abschnitt 2 ist zum Beispiel mit einer Metallfolie oder Metallbeschichtung oder mit einer Leiterstruktur in dem Trägermaterial versehen.

Die Metallisierung des Abschnitts 2 ist derart ausgeführt, dass der Abschnitt 2 eine Elektrode eines Kondensators bildet, der mit einem Spannungsanschluss 3 verbunden ist. Über einen A/D-Wandler 4 wird das empfangene Signal des Sensorelements A einer nicht näher dargestellten Verarbeitungseinheit zugeführt.

Somit bildet das Dekorelement 1 selbst die das Sensorelement A, indem das nichtleitende Trägermaterial als Träger oder Dielektrikum des Abschnitts 2 dient, welcher das Sensorelement A bildet.

Zur Nutzung des als Sensorelement A dienenden Dekorelements 1 beispielsweise zur kapazitiven Annäherungserkennung einer Hand eines Benutzers bildet der metallisierte Abschnitt 2 des Dekorelements 1 eine Annäherungselektrode eines Kondensators und ein sich annäherndes Objekt, z. B. die Hand eines Benutzers, eine Gegenelektrode und Erdung.

Darüber hinaus ist ein solches Dekorelement 1 mit integriertem Sensorelement A innen oder außen am Fahrzeug im Bereich der Fahrzeugaußen- oder -innenhaut für verschiedene Anwendungen, z. B. zur Detektion beispielsweise sich annähernder Objekte zur Warnung vor einer möglichen Kollision oder zur Detektion einer Bewegung, einsetzbar.

### Bezugszeichenliste

- 1: Dekorelement
- 2: Abschnitt
- 3: Spannungsanschluss
- 4: A/D-Wandler

- A: Sensorelement
- Ubat: Spannung

## Patentansprüche

1. Elektrodenanordnung für ein Fahrzeug mit einem Sensorelement (A), welches durch einen Teil eines aus Kunststoff und/oder einem anderen nichtleitfähigen Material gefertigten Zier- oder Dekorelements (1) gebildet ist, wobei das Zier- oder Dekorelement (1) zumindest abschnittsweise metallisiert ausgeführt ist und der metallisierte Abschnitt (2) des Zier- oder Dekorelements (1) als Sensorelement (A) elektrisch angebunden ist, wobei zumindest der metallisierte Abschnitt (2) des Zier- oder Dekorelements (1) die Elektrode eines Kondensators bildet,
**dadurch gekennzeichnet, dass** das Sensorelement (A) eine Annäherungselektrode ist und ein sich annäherndes Objekt eine Gegenelektrode bildet.

2. Elektrodenanordnung nach Anspruch 1,
**dadurch gekennzeichnet, dass** die Elektrodenanordnung eine Antennenanordnung ist, wobei das Sensorelement (A) eine Antenne ist.

3. Elektrodenanordnung nach Anspruch 1 oder 2,
**dadurch gekennzeichnet, dass** das Sensorelement (A) in dem Fahrzeug oder außen am Fahrzeug angeordnet ist.

4. Elektrodenanordnung nach einem der vorhergehenden Ansprüche,
**dadurch gekennzeichnet, dass** das Sensorelement (A) in eine Fahrzeuginnen- oder Fahrzeugaußenhaut integriert ist.

5. Elektrodenanordnung nach einem der vorhergehenden Ansprüche,
**dadurch gekennzeichnet, dass** das Zier- oder Dekorelement (1) Bestandteil einer Anzeigeeinheit in einem Fahrzeuginnenraum ist.

6. Verwendung der Elektrodenanordnung nach einem der Ansprüche 1 bis 5 zur Detektion sich dem Fahrzeug nähernder Objekte.

7. Verwendung nach Anspruch 6,
**dadurch gekennzeichnet, dass** in Abhängigkeit eines erfassten Abstandes zumindest eines detektierten Objektes zu dem Fahrzeug eine Warnung vor einer bevorstehenden Kollision ausgegeben wird.
